(19) **Europäisches Patentamt**

**European Patent Office**

**Office européen des brevets**

(11) **EP 0 620 646 B1**

(12) **EUROPEAN PATENT SPECIFICATION**

(45) Date of publication and mention
of the grant of the patent:
**29.12.1997 Bulletin 1997/52**

(51) Int Cl.$^6$: **H03K 17/56**, H03K 17/687,
H03K 19/0175, H02M 1/08

(21) Application number: **93830159.5**

(22) Date of filing: **09.04.1993**

(54) **Zero bias current low-side driver control circuit**

Steuerschaltung mit keinem Vorspannungsstrom für einen Low-Side-Treiber

Circuit de commande à courant de polarisation nul pour un circuit d'attaque de type low-side

(84) Designated Contracting States:
**CH DE FR GB IT LI**

(43) Date of publication of application:
**19.10.1994 Bulletin 1994/42**

(73) Proprietors:
• **SGS-THOMSON MICROELECTRONICS s.r.l.**
**20041 Agrate Brianza (Milano) (IT)**
• **CONSORZIO PER LA RICERCA SULLA**
**MICROELETTRONICA NEL MEZZOGIORNO**
**95121 Catania (IT)**

(72) Inventors:
• **Milazzo, Patrizia**
**I-98100 Messina (IT)**

• **Bontempo, Gregorio**
**I-98051 Barcellona Pozzo di Gotto (IT)**
• **Alzati, Angelo**
**I-20021 Bollate (IT)**

(74) Representative: **Pellegri, Alberto et al**
**c/o Società Italiana Brevetti S.p.A.**
**Via Puccini, 7**
**21100 Varese (IT)**

(56) References cited:
**EP-A- 0 427 086**     **WO-A-93/01656**

• **PATENT ABSTRACTS OF JAPAN vol. 010, no.
184 (E-415)27 June 1986 &**
• **PATENT ABSTRACTS OF JAPAN vol. 12, no. 167
(E-610)(3014) 19 May 1988 &**

## Description

The present invention relates to output power stages employing a power switch for connecting to a ground node a load and wherein static power consumption within the driving circuit is substantially eliminated.

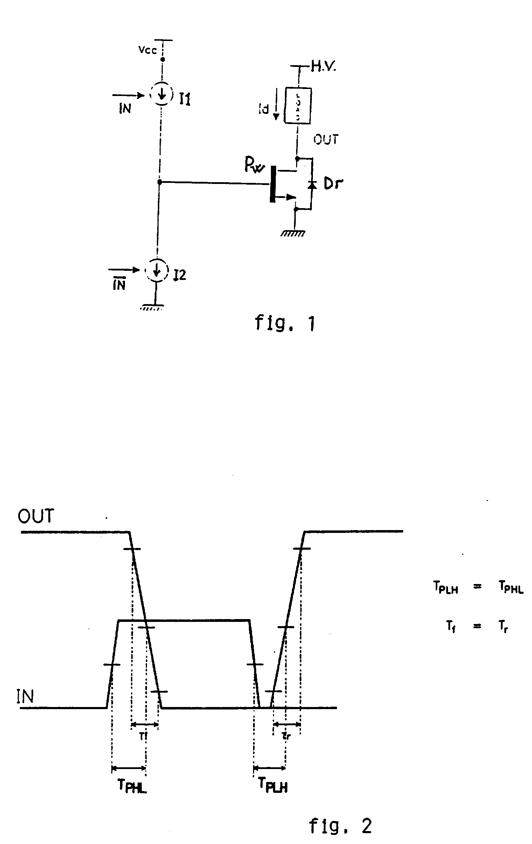

A circuit for switchingly connecting to ground (low-side driver) an external load employing a power switch has a basic diagram as shown in Fig. 1.

Commonly the power switch Pw is a transistor and often an integrated DMOS transistor that notably offers definite advantages over a bipolar junction transistor. The integrated transistor structure intrinsically contains a junction (diode) Dr through which, in case of reactive loads, transient currents may recirculate. The power transistor Pw constitutes the output stage and is controlled by a driving circuit which determines a state of conduction or of nonconduction of the transistor, according to a certain "duty cycle" (in most applications).

In this way, an output signal having an amplitude comprised between Vl=Rdson*Idand Vh=H.V. is produced, where H.V. is the supply voltage to which the external load is connected, Rdson is the saturation resistance of the power transistor Pw and Id is the current through the load.

In order to ensure a low voltage drop through the power transistor Pw when it is conducting, and therefore a low power dissipation, it is necessary to minimize the Rdson value. This is achieved by driving the power transistor with a (gate) voltage that is higher than the voltage that is necessary for switching-on the transistor. Normally, for a DMOS transistor such an overdrive voltage may reach about 10V, i.e. Vgs=10V, that is it may be equal to the supply voltage Vcc of the control circuit.

Moreover, the output signal (OUT) is often required to have certain slew-rate characteristics (Tf and Tr) and delays (Tphl and Tplh), as referred to the control signal (IN), controlled and equal to each other, as depicted in Fig. 2.

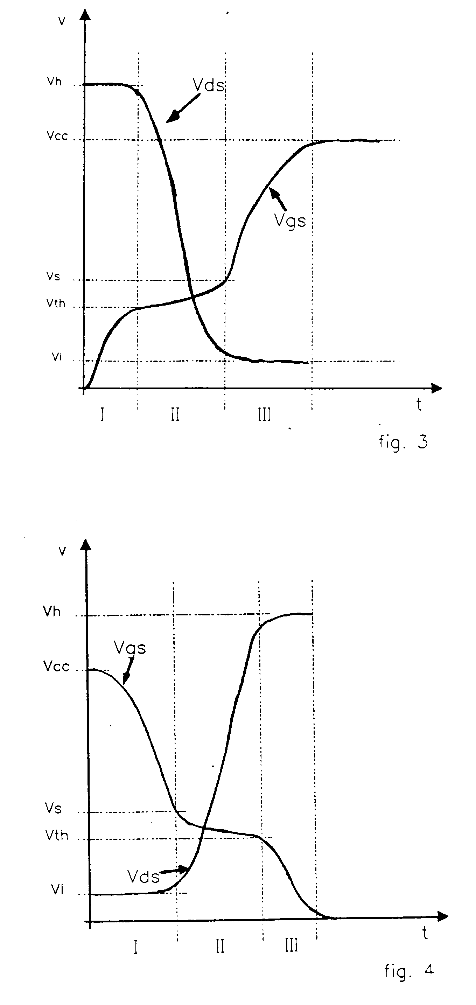

On the other hand, in order to switch-on the power transistor Pw, it is necessary to charge the capacitance of the driving node (gate node) up to a voltage that is higher than the threshold voltage Vth of the transistor. If, during a switch-on phase, driving is effected through a constant current generator I1 (Fig. 1), the gate voltage will have a diagram versus time as the one depicted in Fig. 3. Three different zones of operation of the power transistor may be distinguished, as determined by the actual input capacitance that varies from zone to zone.

In a first zone I of the characteristic, the gate voltage rises from Vgs=OV to Vgs=Vth. In this interval of time no current flows through the power transistor which remains in an off condition. The interval tO-tl is defined as turn-on delay time. After the instant tl, the power transistor starts to conduct and the voltage Vds across the power transistor drops from Vh to Vdson.

In a zone II of the characteristic, normally referred to as the saturation zone, the ratio ΔVds/ΔVgs is high and therefore the Miller effect becomes preponderant in determining the input capacitance as compared with the "physical" gate capacitance of the power transistor. Because of this, the driving current primarily charges the "Miller" capacitance while a negligeable portion of it charges the Cgs capacitance between gate and source of the power transistor Pw, thus causing a negligeable variation of the Vgs voltage. In fact, the gate voltage rises from the value Vgs=Vth to the value Vgs=Vs (Vs is also referred to as the operative voltage). The interval t1-t2 is defined as the fall time Tf.

In the zone II of operation, the gate capacitance charges completely to the voltage Vcc and the power transistor is fully on (low internal resistance).

Similarly, for switching-off the power transistor Pw, its gate capacitance is discharged through a constant current generator I2, which is functionally connected between the gate node of the power transistor and ground. During a "time off" phase phenomena similar to those that occur during the "turn-on" phase takes place, as depicted in Fig. 4. Also in this phase of operation in fact, the gate capacitance discharges through three distinct phases.

In a first phase or zone I of the charactetistic, the gate voltage drops from the value Vgs=Vcc to the operative voltage Vgs=Vs, while the drain voltage remains at Vdson. This interval is defined as the turn-off delay time.

In a second region II of the characteristic, the voltage Vgs drops from Vs to the threshold voltage Vth and during this phase the power transistor Pw starts to carry less and less current until it switches-off completely. The duration of this interval during which the drain voltage rises from Vl to Vh, is defined as the rise time Tr.

If the currents I1 and I2 have the same value, the rise time and the fall time are identical.

In order to have a large charge current (Ic) and a large discharge current (Is) of the gate capacitance of the power transistor Pw for achieving fast switching times, while employing control current generators I1 and I2 of relatively low value, a driving circuit as the one depicted in Fig. 5 is employed. In fact, the relationship that ties the currents Ic and Is to the currents $I_{D1}$ and $I_{D4}$ is of an exponential kind:

$$Ic = n^* I_{D1}\, e^{R^* I_{D1}/Vt}$$

$$Is = n^* I_{D4}\, e^{R^* I_{D4}/Vt}$$

If $I_{D1}$ and $I_{D4}$ are equal, the currents Ic and Is will be equal and so also the fall time and the rise time.

In practice, in a circuit as the one depicted in Fig. 5, the current $I_{D4}$ is different from $I_{D1}$. In fact, the MOS M1 and M2 operate with a constant Vgs, therefore the current $I_{D1}=I$, while the MOS M3 and M4 operates with a Vgs that varies because their source is not connected to a fixed voltage, but to the gate of the power transistor Pw, the voltage of which drops during a turn-off phase. Therefore, $I_{D4} \neq I$.

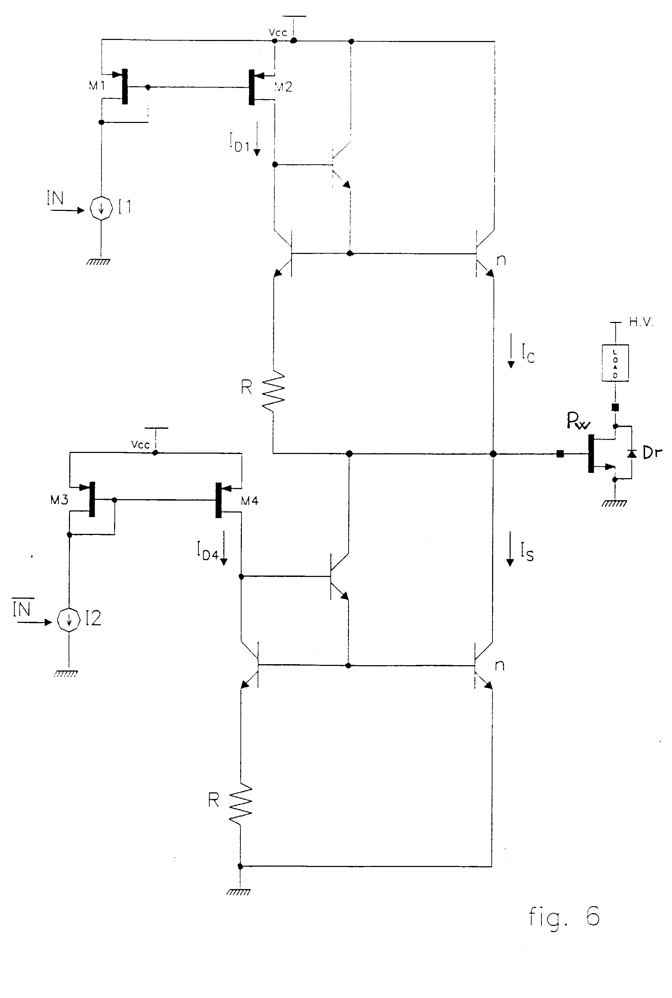

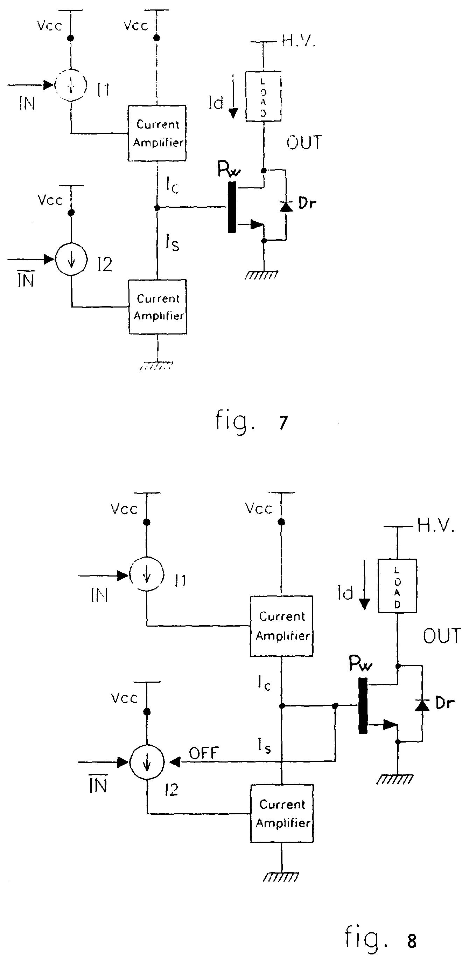

Commonly, in order to obviate to this drawback, the sources of M3 and M4 are connected to a fixed voltage, for example to the supply voltage Vcc, so that, the current mirror formed by M3-M4, generates the same current as the current mirror M1-M2. Such a knonw solution is depicted in Fig. 6, and a functional block diagram may be depicted as in Fig. 7.

In this circuit, the transistors M2 and M4 do not exactly operate under the same conditions. In fact, M4 operates always in a saturation zone, with Vgs1=constant and Vds1=constant=Vcc-2Vbe, and the transistor M2 operates in a saturation zone until Vds2=Vgs2-Vth and thereafter operates in a linear zone. When M2 operates in a linear zone, the gate voltage of the power transistor Pw has already risen above the operative voltage Vs, therefore the transistor no longer operates in the zone II and therefore the drain of the transistor has already assumed the voltage Vh.

This circuit has a drawback represented by the fact that when the power transistor Pw is off, and therefore its gate voltage is Vgs=0V, a certain current consumption (drawn from the supply line Vcc) occurs and is given by the sum: $I2+I_{D4}$.

In integrated circuits where numerous driving stages of this type are present, such a static current consumption may reach untolerable levels.

A main objective of the invention is to provide an improved control circuit for a low-side driver stage that without penalizing speed and precision characteristics has a substantially null static current consumption.

This objective is reached with the driver circuit of the present invention, which is characterized by the features recited in claim 1, which form a switch capable of preventing any flow of current through the discharge current generator of the control node capacitance of the power transistor, when the latter is in an off state. Such a switch is controlled by the voltage present on the control node of the power transistor. In practice, the driving circuit of the invention has a null static consumption when the power transistor is off and an extremely low consumption which would practically negligeable, when the power transistor is on.

The invention will be more easily understood through the following description of an important embodiment that is herein incorporated by express reference.

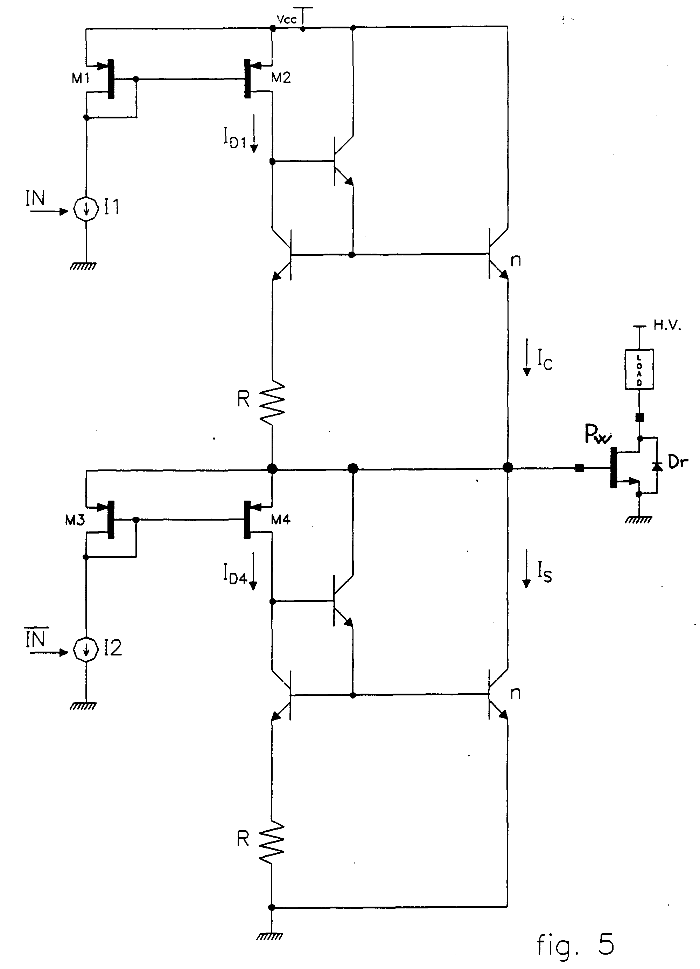

**Figures 1**, **2**, **3**, **4**, **5**, **6** and **7**, as already described above, illustrate the state of the prior art.

**Figure 8** is a block diagram of a driving circuit made in accordance with the present invention.

**Figure 9** is a driving circuit made in accordance with the present invention.

As schematically shown in Fig. 8, the driving circuit of the invention comprises a switch (OFF) capable of interrupting any current flow through the current generator I2 that is employed for discharging the capacitance of the control node (gate) of the output power transistor Pw. The switch (OFF) is controlled by the voltage present on the control node of the power transistor Pw and practically eliminates any (static) consumption of current when the power transistor Pw is off.

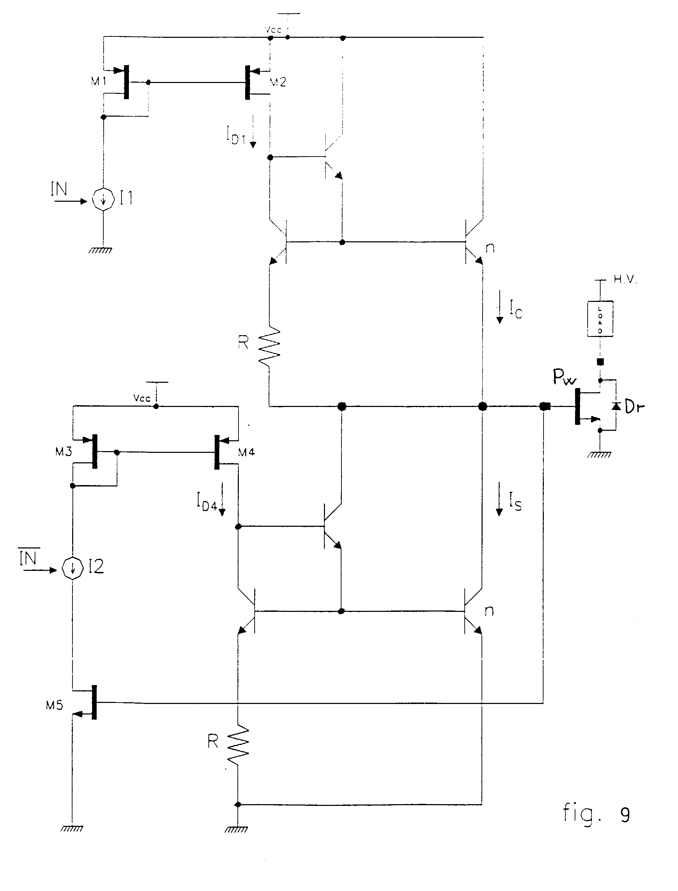

The electrical diagram of Fig. 9 shows an embodiment of the circuit of the invention in the case of a driving circuit which, under other aspects, may be entirely similar to the functional circuit of Fig. 6. The switch (OFF) of Fig. 8 is constituted by a MOS transistor M5 in the example shown.

When the power transistor Pw switches-off, while its gate voltage drops, also the gate voltage of the transistor M5 decreases.

In this switching-off phase, the resistance Rdson of the transistor M5 increases, thus causing a "mismatch" between the currents I1 and I2. By dimensioning the transistor M5 so that such a "mismatch" manifests itself in a significant manner when the power transistor Pw has already come out of saturation, the mismatch will not represent practically any problem because the power transistor has already switched-off. Of course, the transistor M5 may be dimensioned in a way that its Rdson be practically negligeable until the gate potential of the output power transistor has dropped to a value that has surely made the power transistor Pw exit a saturation condition.

Therefore, the transistor M5 behaves as a switch that opens when the gate voltage of the power transistor drops below the value of the threshold voltage of M5, thus interrupting the current flow in the branch I2 of driving circuit.

The introduction of a switch (M5) in series with the current generator (I2) does not modify other functional characteristics of the driving circuit, which retains its speed characteristics, moreover rise and fall times may remain are identical to each other and more generally may be controlled. On the other hand the static consumption of current when the power transistor is off is totally eliminated. The circuit arrangement of the invention is simple to implement and requires a minimum additional area of integration.

## Claims

1. A low side driver circuit employing a power transistor (Pw) driven into conduction by a voltage higher than its threshold voltage and comprising a first current generator controlled by a first switching signal (IN), and capable of delivering a current for charging the capacitance of a driving node of the power transistor, a second current generator controlled by a complementary switching signal ($\overline{IN}$), and capable of delivering a current for discharging said capacitance of the driving node of the power transistor, characterized by comprising further

means (M5) for interrupting the passage of current through said second current generator when the output power transistor is off, said means being controlled by the voltage present on said driving node of output power transistor.

2. A driving circuit as defined in claim 1, wherein said power transistor is an integrated DMOS transistor.

3. A driving circuit according to claim 1, wherein said means comprise a MOS transistor functionally connected in series with said second current generator.

4. A low-side driver circuit according to one of claims 1 to 3, wherein said first current generator comprises a first current mirror (M1,M2), driven by a current source (I1) that is controlled by said first switching signal, wherein said second current generator comprises a second current mirror (M3,M4), driven by a current source (I2) that is controlled by said complementary switching signal ($\overline{\text{IN}}$) of said first signal, said means for interrupting comprising

a switch (M5), controlled by the voltage present on said driving node of said power transistor and functionally connected between said current source in said second current generator and a ground node of the circuit.

5. A driving circuit as defined in claim 4, wherein said power transistor is an integrated DMOS transistor.

6. A driving circuit as defined in claim 4, wherein said switch is a MOS transistor.

7. A driving circuit as defined in claim 4, wherein both said current mirrors are functionally connected between a supply node and said ground node of the circuit.

**Patentansprüche**

1. Niederspannungsseitige Treiberschaltung, die einen Leistungstransistor (Pw) verwendet, der durch eine Spannung, die höher ist als seine Schwellenspannung, in einen leitenden Zustand versetzt wird, und die versehen ist mit einem ersten Stromgenerator, der durch ein erstes Schaltsignal (IN) gesteuert wird und einen Strom zum Aufladen der Kapazität eines Ansteuerungsknotens des Leistungstransistors liefern kann, einem zweiten Stromgenerator, der durch ein komplementäres Schaltsignal ($\overline{\text{IN}}$) gesteuert wird und einen Strom zum Entladen der Kapazität des Ansteuerungsknotens des Leistungstransistors liefern kann,

dadurch gekennzeichnet, daß sie ferner enthält

eine Vorrichtung (M5) zum Unterbrechen des Stromweges über den zweiten Stromgenerator, wenn der Endstufenleistungstransistor abgeschaltet ist, wobei die Vorrichtung durch die am Ansteuerungsknoten des Endstufenleistungstransistors anliegende Spannung gesteuert wird.

2. Treiberschaltung nach Anspruch 1, bei der der Leistungstransistor ein integrierter DMOS-Transistor ist.

3. Treiberschaltung nach Anspruch 1, bei der die Vorrichtung einen MOS-Transistor enthält, der funktionell mit dem zweiten Stromgenerator in Serie geschaltet ist.

4. Niederspannungsseitige Treiberschaltung nach einem der Ansprüche 1 bis 3, in der der erste Stromgenerator einen ersten Stromspiegel (M1, M2) enthält, der durch eine Stromquelle (I1) getrieben wird, die durch das erste Schaltsignal gesteuert wird, und wobei der zweite Stromgenerator einen zweiten Stromspiegel (M3, M4) enthält, der durch eine Stromquelle (I2) getrieben wird, die durch das zum ersten Signal komplementäre Schaltsignal ($\overline{\text{IN}}$) gesteuert wird,

wobei die Vorrichtung zum Unterbrechen enthält:

einen Schalter (M5), der durch die am Ansteuerungsknoten des Leistungstransistors anliegende Spannung gesteuert wird und funktionell zwischen der Stromquelle im zweiten Stromgenerator und einem Masseknoten der Schaltung angeschlossen ist.

5. Treiberschaltung nach Anspruch 4, in der der Leistungstransistor ein integrierter DMOS-Transistor ist.

6. Treiberschaltung nach Anspruch 4, in der der Schalter ein MOS-Transistor ist.

7. Treiberschaltung nach Anspruch 4, in der beide Stromspiegel funktionell zwischen einem Stromversorgungsknoten und dem Masseknoten der Schaltung angeschlossen sind.

**Revendications**

1. Circuit de mise à niveau bas utilisant un transistor de puissance (Pw) piloté en conduction par une tension supérieure à sa tension de seuil comprenant un premier générateur de courant commandé par un premier signal de commutation (IN) et capable de fournir un courant pour charger la capacité d'un noeud de commande du transistor de puissance, un second générateur de courant commandé par un signal de commutation complémentaire ($\overline{\text{IN}}$) et capable de fournir un courant pour décharger la capacité du noeud de commande du transistor de puissance,

caractérisé en ce qu'il comprend en outre un moyen (M5) pour interrompre le passage du courant dans le second générateur de courant quand le transistor de puissance de sortie est bloqué, ce moyen étant commandé par la tension présente sur le noeud de commande du transistor de puissance de sortie.

2. Circuit de commande selon la revendication 1, dans lequel le transistor de puissance est un transistor DMOS intégré.

3. Circuit de commande selon la revendication 1, dans lequel ledit moyen comprend un transistor MOS fonctionnellement connecté en série avec le second générateur de courant.

4. Circuit de mise à niveau bas selon l'une des revendications 1 à 3, dans lequel le premier générateur de courant comprend un premier miroir de courant (M1, M2) piloté par une source de courant (I1) qui est commandé par le premier signal de commutation, dans lequel le second générateur de courant comprend un second miroir de courant (M3, M4) piloté par le signal de commutation complémentaire ($\overline{\text{IN}}$) du premier signal, ledit moyen d'interruption comprenant un commutateur (M5) commandé par la tension présente sur le noeud de commande du transistor de puissance et fonctionnellement connecté entre la source de courant (I2) du second générateur de courant et un noeud de masse du circuit.

5. Circuit de commande selon la revendication 4, dans lequel le transistor de puissance est un transistor DMOS intégré.

6. Circuit de commande selon la revendication 4, dans lequel ledit commutateur est un transistor MOS.

7. Circuit de commande selon la revendication 4, dans lequel les miroirs de courant sont fonctionnellement connectés entre un noeud d'alimentation et le noeud de masse du circuit.

fig. 1

$$T_{PLH} = T_{PHL}$$

$$T_f = T_r$$

fig. 2

6

fig. 3

fig. 4

fig. 5

fig. 6

fig. 7

fig. 8

fig. 9